# EUROPÄISCHE PATENTANMELDUNG

(11) **EP 4 105 986 A1**
(43) Veröffentlichungstag der Anmeldung: **21.12.2022**
(21) Anmeldenummer: 21179816.0
(22) Anmeldetag: 16.06.2021
(51) Int. Cl.: H01L 25/075, H01L 33/50

(54) **LEUCHTMITTEL ZUR ERZEUGUNG WEISSEN LICHTS**

(71) Anmelder: Siteco GmbH, 83301 Traunreut (DE)
(72) Erfinder: Schleicher, Gotthard, 83379 Wonneberg (DE)
(74) Vertreter: Schmidt, Steffen

(57) **Zusammenfassung**

Die Erfindung betrifft ein Leuchtmittel (100) zum Erzeugen weißen Lichts, wobei das Leuchtmittel eine erste Leuchtdiode (110) und eine zweite Leuchtdiode (130) sowie einen ersten Leuchtstoff (120) und einen zweiten Leuchtstoff (140) aufweist. Dabei weisen Emissionsspektra der ersten Leuchtdiode, des ersten Leuchtstoffs, der zweiten Leuchtdiode und des zweiten Leuchtstoffs jeweils Maxima bei einer ersten, einer zweiten, einer dritten und einer vierten Wellenlänge auf, wobei die zweite Wellenlänge größer als die erste Wellenlänge ist, die dritte Wellenlänge größer als die zweite Wellenlänge ist, und die vierte Wellenlänge größer als die dritte Wellenlänge ist.

## Beschreibung

### Gebiet der Erfindung

Die Erfindung betrifft ein Leuchtmittel mit mehreren Leuchtdioden und Leuchtstoffen.

### Hintergrund

Zur Erzeugung weißen Lichts werden heute vielfach Leuchtmittel verwendet, die eine Leuchtdiode sowie einen oder mehrere Leuchtstoffe umfassen, wobei die Leuchtstoffe zur Konvertierung zumindest eines Teils des von der Leuchtdiode erzeugten Lichts in langwelligeres Licht ausgeführt sind. Nachfolgend wird der Begriff Licht für elektromagnetische Strahlung verwendet, die für das menschliche Auge sichtbar ist, es können aber auch elektromagnetische Wellen kürzerer Wellenlänge (ultraviolett) und größerer Wellenlänge (infrarot) damit gemeint sein.

Die in konventionellen Leuchtmitteln zur Erzeugung weißen Lichts verwendeten Leuchtdioden sind Lumineszenzhalbleiter, die beispielsweise ultraviolettes oder blaues Licht erzeugen. Ferner sind die Leuchtstoffe photolumineszierende Farbstoffe zur Umwandlung zumindest eines Teils des von der Leuchtdiode erzeugten Lichts in insbesondere grünes, gelbes, oder rotes Licht. Bei der Konvertierung des von der Leuchtdiode erzeugten Lichts in langwelligeres Licht wird ein Teil der Energie der von der Leuchtdiode emittierten Photonen dissipiert.

### Zusammenfassung der Erfindung

Eine Aufgabe besteht darin, ein energieeffizientes Leuchtmittel zur Erzeugung weißen Lichts bereitzustellen.

Diese Aufgabe wird durch den Gegenstand des unabhängigen Patentanspruchs gelöst. Weiterbildungen der Erfindung ergeben sich aus den Unteransprüchen und der folgenden Beschreibung.

Ein erster Aspekt der Erfindung betrifft ein Leuchtmittel, aufweisend eine erste Leuchtdiode und eine zweite Leuchtdiode sowie einen ersten und einen zweiten Leuchtstoff. Dabei weist das Emissionsspektrum der ersten Leuchtdiode ein Maximum bei einer ersten Wellenlänge auf, und das Emissionsspektrum der zweiten Leuchtdiode weist ein Maximum bei einer dritten Wellenlänge auf. Ferner weist das Emissionsspektrum des ersten Leuchtstoffs ein Maximum bei einer zweiten Wellenlänge auf, und das Emissionsspektrum des zweiten Leuchtstoffs weist ein Maximum bei einer vierten Wellenlänge auf. Dabei ist die vierte Wellenlänge größer als die dritte Wellenlänge, die dritte Wellenlänge ist größer als die zweite Wellenlänge, und die zweite Wellenlänge ist größer als die erste Wellenlänge.

Insbesondere ist das Leuchtmittel zur Erzeugung weißen Lichts ausgeführt. Dabei kann die erste Leuchtdiode dazu ausgeführt sein, elektromagnetische Strahlung in einem ersten Spektralbereich bereitzustellen, beispielsweise blaues oder ultraviolettes Licht. Der erste Leuchtstoff kann dazu ausgeführt sein, zumindest einen Teil der von der ersten Leuchtdiode erzeugten elektromagnetischen Strahlung umzuwandeln, um Licht in einem zweiten Spektralbereich zu emittieren, wobei der zweite Spektralbereich größere Wellenlängen als der erste Spektralbereich umfasst. Der zweite Spektralbereich kann mit dem ersten Spektralbereich teilweise überlappen.

Ferner kann die zweite Leuchtdiode dazu ausgeführt sein, Licht in einem dritten Spektralbereich bereitzustellen, wobei der dritte Spektralbereich größere Wellenlängen als der zweite Spektralbereich umfasst. Es ist auch möglich, dass der dritte Spektralbereich mit dem zweiten Spektralbereich überlappt. Beispielsweise kann die zweite Leuchtdiode grünes oder gelbes Licht emittieren. Der zweite Leuchtstoff kann dazu ausgeführt sein, zumindest einen Teil des von der zweiten Leuchtdiode erzeugten Lichts umzuwandeln, um Licht in einem vierten Spektralbereich zu emittieren, wobei der vierte Spektralbereich größere Wellenlängen als der dritte Spektralbereich umfasst. Beispielsweise kann der zweite Leuchtstoff zum Emittieren roten Lichts ausgeführt sein. Der vierte Spektralbereich kann mit dem dritten Spektralbereich teilweise überlappen.

Ein konventionelles Leuchtmittel zur Erzeugung weißen Lichts weist eine Leuchtdiode im ultravioletten oder blauen Spektralbereich und eine oder mehrere Leuchtstoffe auf. Dabei kann die mittlere Energiedifferenz zwischen den von der Leuchtdiode emittierten Photonen und den von den Leuchtstoffen emittierten Photonen groß sein, sodass ein großer Teil der von der Leuchtdiode emittierten Energie dissipiert.

Demgegenüber können bei den anspruchsgemäßen Leuchtmitteln die erste Leuchtdiode und der erste Leuchtstoff einen kurzwelligen Spektralbereich abdecken während die zweite Leuchtdiode und der zweite Leuchtstoff einen langwelligen Spektralbereich abdecken. Die mittlere Energiedifferenz zwischen den von der ersten Leuchtdiode emittierten Photonen und den von dem ersten Leuchtstoff emittierten Photonen sowie die mittlere Energiedifferenz zwischen den von der zweiten Leuchtdiode emittierten Photonen und den von dem zweiten Leuchtstoff emittierten Photonen können dabei gering sein, sodass ein geringer Anteil der von den Leuchtdioden abgestrahlten Energie dissipiert. Dies kann ein energieeffizientes Erzeugen weißen Lichts ermöglichen.

Das Leuchtmittel kann dazu ausgeführt sein, dass die erste Leuchtdiode und die zweite Leuchtdiode separat angesteuert werden können. Dies kann eine Regelung der Farbtemperatur und/oder des Farbwiedergabeindexes (color rendering index, CRI) ermöglichen.

In einigen Ausführungsformen kann von der ersten Leuchtdiode und von dem ersten Leuchtstoff emittiertes Licht auf den zweiten Leuchtstoff treffen. Ferner kann von der zweiten Leuchtdiode und von dem zweiten Leuchtstoff emittiertes Licht auf den ersten Leuchtstoff treffen. Um eine Absorption von Licht zu vermeiden, ist der erste Leuchtstoff vorzugsweise transparent für von der zweiten Leuchtdiode und dem zweiten Leuchtstoff emittiertes Licht, und der zweite Leuchtstoff ist vorzugsweise transparent für von der ersten Leuchtdiode und dem ersten Leuchtstoff emittiertes Licht.

Gemäß einer Ausführungsform ist die erste Wellenlänge größer als 400 nm und/oder kleiner als 500 nm.

Somit kann die erste Leuchtdiode blaues Licht emittieren. Die erste Wellenlänge ist die Dominanzwellenlänge der ersten Leuchtdiode, und das Emissionsspektrum der ersten Leuchtdiode kann im Vergleich zu dem Emissionsspektrum des ersten Leuchtstoffs schmalbandig sein.

In einer anderen Ausführungsform kann die erste Leuchtdiode dazu ausgeführt sein, ultraviolettes Licht zu emittieren. Beispielsweise kann die erste Wellenlänge größer als 340 nm und/oder kleiner als 400 nm sein.

Gemäß einer weiteren Ausführungsform weist die erste Leuchtdiode Indiumgalliumnitrid, Galliumnitrid, Zinkselenid, Siliziumkarbid, Silizium als Träger, und/oder Zinkoxid auf.

Leuchtdioden zum Erzeugen blauen Lichts können Indiumgalliumnitrid, Galliumnitrid, Zinkselenid, Siliziumkarbid, Silizium als Träger, und/oder Zinkoxid aufweisen. Im einschlägigen Stand der Technik sind weitere Materialien zur Herstellung von Leuchtdioden, die blaues Licht emittieren, bekannt.

Insbesondere kann InₓGa₁₋ₓN aus Galliumnitrid und Indiumnitrid gebildet werden. Abhängig von dem Verhältnis von Galliumnitrid und Indiumnitrid können violette, blaue, und grüne Leuchtdioden hergestellt werden. Beispielsweise kann eine Leuchtdiode mit einem Verhältnis von 2 % Indiumnitrid und 98 % Galliumnitrid ultraviolette Strahlung abstrahlen. Ferner kann eine Leuchtdiode mit einem Verhältnis von 20 % Indiumnitrid und 80 % Galliumnitrid blau-violettes Licht mit einer Wellenlänge von 420 nm abstrahlen. Ferner kann eine Leuchtdiode mit einem Verhältnis von 30 % Indiumnitrid und 70 % Galliumnitrid blaues Licht mit einer Wellenlänge von 440 nm abstrahlen.

Leuchtdioden zum Erzeugen ultravioletter elektromagnetischer Strahlung können beispielsweise Indiumgalliumnitrid, Aluminiumnitrid, Aluminiumgalliumnitrid und/oder Aluminiumgalliumindiumnitrid aufweisen. Beispielsweise können Leuchtdioden auf der Grundlage von Aluminiumgalliumnitrid unterschiedliche Al/Ga-Anteile aufweisen, und wenn unlegiertes GaN zur Bildung aktiver Quantentopfschichten verwendet wird, so kann die Leuchtdiode nah-ultraviolette Strahlung mit einer Wellenlänge von 365 nm abstrahlen.

Gemäß einer weiteren Ausführungsform liegt die erste Wellenlänge, d.h. die Dominanzwellenlänge der ersten Leuchtdiode, innerhalb einer Halbwertsbreite eines Absorptionsspektrums des ersten Leuchtstoffs.

Die erste Leuchtdiode und der erste Leuchtstoff können dazu ausgeführt sein, dass mehr als 20 %, mehr als 40%, mehr als 80% oder mehr als 90% der von der ersten Leuchtdiode emittierten Photonen von dem ersten Leuchtstoff absorbiert werden.

Gemäß einer weiteren Ausführungsform liegt die dritte Wellenlänge, d.h. die Dominanzwellenlänge der zweiten Leuchtdiode, innerhalb einer Halbwertsbreite eines Absorptionsspektrums des zweiten Leuchtstoffs.

Die zweite Leuchtdiode und der zweite Leuchtstoff können dazu ausgeführt sein, dass mehr als 20 %, mehr als 40%, mehr als 80% oder mehr als 90% der von der zweiten Leuchtdiode emittierten Photonen von dem zweiten Leuchtstoff absorbiert werden.

Gemäß einer weiteren Ausführungsform weist das Absorptionsspektrum des ersten Leuchtstoffs ein Maximum bei einer fünften Wellenlänge auf, wobei eine Differenz zwischen der zweiten Wellenlänge und der fünften Wellenlänge kleiner als 100 nm ist.

Mit anderen Worten ist die Differenz zwischen den Wellenlängen, bei denen die Maxima der der Emissions- und Absorptionsspektren des ersten Leuchtstoffs liegen, kleiner als 100 nm. Insbesondere kann der erste Leuchtstoff einen hohen Wirkungsgrad aufweisen, wenn die Absorptionsbande des ersten Leuchtstoffs an die Emissionsbande dieses Leuchtstoffs angrenzt, sodass eine mittlere Energiedifferenz zwischen den von dem ersten Leuchtstoff absorbierten Photonen und den von diesem Leuchtstoff emittierten Photonen gering ist. Mit anderen Worten kann der erste Leuchtstoff einen hohen Wirkungsgrad aufweisen, wenn die von dem ersten Leuchtstoff absorbierten Photonen nur wenig im kurzwelligeren liegen als die von dem ersten Leuchtstoff emittierten Photonen. Vorzugsweise ist die Differenz zwischen der zweiten Wellenlänge und der fünften Wellenlänge kleiner als 75 nm.

Insbesondere wenn die erste Leuchtdiode ultraviolettes Licht emittiert, kann die Differenz zwischen der zweiten Wellenlänge und der fünften Wellenlänge zwischen 100 nm und 120 nm oder zwischen 120 nm und 150 nm liegen.

Gemäß einer weiteren Ausführungsform weist das Absorptionsspektrum des zweiten Leuchtstoffs ein Maximum bei einer sechsten Wellenlänge auf, wobei eine Differenz zwischen der vierten Wellenlänge und der sechsten Wellenlänge kleiner als 170 nm ist.

Mit anderen Worten ist die Differenz zwischen den Wellenlängen, bei denen die Maxima der der Emissions- und Absorptionsspektren des zweiten Leuchtstoffs liegen, kleiner als 170 nm. Insbesondere kann der zweite Leuchtstoff einen hohen Wirkungsgrad aufweisen, wenn die Absorptionsbande des zweiten Leuchtstoffs an die Emissionsbande dieses Leuchtstoffs angrenzt, sodass eine mittlere Energiedifferenz zwischen den von dem zweiten Leuchtstoff absorbierten Photonen und den von diesem Leuchtstoff emittierten Photonen gering ist. Mit anderen Worten kann der zweite Leuchtstoff einen hohen Wirkungsgrad aufweisen, wenn die von dem zweiten Leuchtstoff absorbierten Photonen nur wenig im kurzwelligeren liegen als die von dem zweiten Leuchtstoff emittierten Photonen. Vorzugsweise ist die Differenz zwischen der vierten Wellenlänge und der sechsten Wellenlänge kleiner als 150 nm. Die Differenz zwischen der vierten Wellenlänge und der sechsten Wellenlänge kann in einigen Ausführungsformen auch kleiner als 120 nm oder kleiner als 100 nm sein.

Gemäß einer weiteren Ausführungsform weist das Emissionsspektrum des ersten und/oder des zweiten Leuchtstoffs eine Halbwertsbreite von weniger als 100 nm auf. Insbesondere kann das Emissionsspektrum des ersten oder zweiten Leuchtstoffs eine Halbwertsbreite von weniger als 100 nm aufweisen. Für den jeweils anderen Leuchtstoff kann es zum Erzielen eines guten Farbwiedergabeindexes von Vorteil sein, wenn die Halbwertsbreite zwischen 100 nm und 150 nm oder zwischen 150 nm und 200 nm liegt.

Leuchtstoffe mit geringer Halbwertsbreite des Emissionsspektrums können den Vorteil haben, dass die mittlere Energiedifferenz zwischen den von dem Leuchtstoff absorbierten Photonen und den von dem Leuchtstoff emittierten Photonen gering ist, sodass ein hoher Wirkungsgrad ermöglicht werden kann. Dies gilt insbesondere, wenn die Absorptionsbande des Leuchtstoffs an dessen Emissionsbande heranreicht.

Gemäß einer weiteren Ausführungsform ist der erste und/oder der zweite Leuchtstoff ein Eu²⁺ aktivierter Leuchtstoff.

Ein Eu²⁺-aktivierter Leuchtstoff kann vorteilhaft sein, da der Abstand zwischen seiner Absorptionsbande und seiner Emissionsbande gering sein kann. Dadurch kann erreicht werden, dass die mittlere Energiedifferenz zwischen den von dem Leuchtstoff absorbierten Photonen und den von dem Leuchtstoff emittierten Photonen gering ist, sodass ein hoher Wirkungsgrad erzielt werden kann.

Gemäß einer weiteren Ausführungsform weist der erste Leuchtstoff BaMgAl₁₀O₁₇:Eu²⁺, Sr₅(PO₄)₃Cl:Eu²⁺ und/oder (Sr,Ca,Ba)₅(PO₄)₃Cl:Eu²⁺ auf.

Beispielsweise weist das Emissionsspektrum des Leuchtstoffs BaMgAl₁₀O₁₇:Eu²⁺ ein Maximum bei ca. 480 nm auf. Dieser Leuchtstoff ist auch unter der Bezeichnung BAM bekannt.

Gemäß einer weiteren Ausführungsform ist die dritte Wellenlänge größer als 500 nm und/oder kleiner als 570 nm.

Somit kann die zweite Leuchtdiode dazu ausgeführt sein, grünes Licht zu emittieren. Die dritte Wellenlänge ist die Dominanzwellenlänge der zweiten Leuchtdiode, und das Emissionsspektrum der zweiten Leuchtdiode kann im Vergleich zu dem Emissionsspektrum des zweiten Leuchtstoffs schmalbandig sein. In einer weiteren Ausführungsform kann die zweite Leuchtdiode dazu ausgeführt sein, beispielsweise gelbes Licht zu emittieren.

Die Dominanzwellenlänge der zweiten Leuchtdiode kann in einem oberen Wellenlängenbereich der Emissionsbande des ersten Leuchtstoffs liegen. Beispielsweise kann der Wert des Emissionsspektrums des ersten Leuchtstoffs bei der Dominanzwellenlänge der zweiten Leuchtdiode weniger als 10 dB unterhalb des Maximums des Emissionsspektrums des ersten Leuchtstoffs liegen.

In einer weiteren Ausführungsform kann die Dominanzwellenlänge der zweiten Leuchtdiode oberhalb der Emissionsbande des ersten Leuchtstoffs liegen. Insbesondere kann der Wert des Emissionsspektrums des ersten Leuchtstoffs bei der Dominanzwellenlänge der zweiten Leuchtdiode mehr als 10 dB unterhalb des Maximums des Emissionsspektrums des ersten Leuchtstoffs liegen.

Gemäß einer weiteren Ausführungsform weist die zweite Leuchtdiode Galliumphosphid, Indiumgalliumnitrid/Galliumnitrid, Aluminiumgalliumindiumphosphid, Aluminiumgalliumphosphid und/oder Zinkoxid auf.

Leuchtdioden zum Erzeugen grünen Lichts können Galliumphosphid, Indiumgalliumnitrid/Galliumnitrid, Aluminiumgalliumindiumphosphid, Aluminiumgalliumphosphid und/oder Zinkoxid aufweisen.

Leuchtdioden zum Erzeugen gelben Lichts können Galliumarsenidphosphid, Aluminiumgalliumindiumphosphid und/oder Galliumphosphid aufweisen.

Weitere Materialien zur Herstellung von Leuchtdioden, die grünes oder gelbes Licht emittieren, sind im Stand der Technik bekannt.

Gemäß einer weiteren Ausführungsform ist die vierte Wellenlänge kleiner als 700 nm.

Insbesondere kann der zweite Leuchtstoff dazu ausgeführt sein, oranges und rotes Licht zu emittieren. Die vierte Wellenlänge ist vorzugsweise kleiner als 700 nm, sodass der zweite Leuchtstoff nur wenig im infraroten Spektralbereich emittiert.

Gemäß einer weiteren Ausführungsform weist der zweite Leuchtstoff Ba₂Si₅N₈:Eu²⁺, MgS:Eu²⁺, SrS:Eu²⁺, Sr₂Si₅N₈:Eu²⁺, CaAlSiN₃:Eu²⁺, CaS:Eu²⁺ und/oder Sr(LiAl₃N₄):Eu²⁺ auf.

Wie oben bereits dargelegt kann ein Eu²⁺-aktivierter Leuchtstoff vorteilhaft sein, da seine Absorptionsbande bis an die Emissionsbande heranreichen kann. Dadurch kann erreicht werden, dass eine mittlere Energiedifferenz zwischen den von dem Leuchtstoff absorbierten Photonen und den von dem Leuchtstoff emittierten Photonen gering ist, sodass ein hoher Wirkungsgrad erzielt werden kann.

Aus "Spectral optimization of phosphor-conversion light-emitting diodes for ultimate color rendering" von A. Žukauskas et al., Appl. Phys. Lett. 93, 051115 (2008) ist ferner Folgendes bekannt.

Der Leuchtstoff Ba₂Si₅N₈:Eu²⁺ kann ein Emissionsspektrum mit einem Maximum bei einer Wellenlänge von 580 nm und einer Halbwertsbreite von 60 nm bereitstellen.

Der Leuchtstoff MgS:Eu²⁺ kann ein Emissionsspektrum mit einem Maximum bei einer Wellenlänge von 590 nm und einer Halbwertsbreite von 40 nm bereitstellen.

Der Leuchtstoff SrS:Eu²⁺ kann ein Emissionsspektrum mit einem Maximum bei einer Wellenlänge von 615 nm und einer Halbwertsbreite von 60 nm bereitstellen.

Der Leuchtstoff Sr₂Si₅N₈:Eu²⁺ kann ein Emissionsspektrum mit einem Maximum bei einer Wellenlänge von 615 nm und einer Halbwertsbreite von 80 nm bereitstellen.

Der Leuchtstoff CaAlSiN₃:Eu²⁺ kann ein Emissionsspektrum mit einem Maximum bei einer Wellenlänge von 650 nm und einer Halbwertsbreite von 90 nm bereitstellen.

Der Leuchtstoff CaS:Eu²⁺ kann ein Emissionsspektrum mit einem Maximum bei einer Wellenlänge von 655 nm und einer Halbwertsbreite von 65 nm bereitstellen.

Ferner ist aus "Narrow-band red-emitting Sr(LiAl3N4):Eu2+ as a next-generation LEDphosphor material" von P. Pust et al., Nature Materials, vol. 13, no. 9, Sep. 2014 bekannt, dass das Emissionsspektrum des Leuchtstoffs Sr(LiAl₃N₄):Eu²⁺ ein Maximum bei einer Wellenlänge von 650 nm aufweisen kann.

Beispielsweise kann ein Leuchtmittel eine erste Leuchtdiode aus InₓGa₁₋ₓN mit 20% bis 30% Indiumnitrid und 70% bis 80% Galliumnitrid, einen ersten Leuchtstoff aus BaMgAl₁₀O₁₇:Eu²⁺, eine zweite Leuchtdiode aus Galliumphosphid und einen zweiten Leuchtstoff aus Ba₂SiN₈:Eu²⁺ aufweisen. Weitere Ausführungsformen erfindungsgemäßer Leuchtmittel ergeben sich, wenn das Material der ersten Leuchtdiode, des ersten Leuchtstoffs, der zweiten Leuchtdiode und/oder des zweiten Leuchtstoffs durch andere der für das jeweilige Leuchtmittelelement oben genannten Materialien ersetzt werden. Es ist beabsichtigt, dass der Offenbarungsgehalt der vorliegenden Patentanmeldung alle Kombinationen der für die erste Leuchtdiode, den ersten Leuchtstoff, die zweite Leuchtdiode und den zweiten Leuchtstoff oben genannten Materialien umfasst.

Gemäß einer weiteren Ausführungsform weist das Leuchtmittel ferner eine dritte Leuchtdiode auf, wobei ein Emissionsspektrum der dritten Leuchtdiode ein Maximum bei einer siebten Wellenlänge aufweist, und wobei die siebte Wellenlänge größer als die vierte Wellenlänge ist.

Die dritte Leuchtdiode kann eine Aufteilung des sichtbaren Spektralbereichs in schmalbandigere Abschnitte ermöglichen. Dies kann eine Verbesserung des Wirkungsgrads des Leuchtmittels ermöglichen, da die mittlere Energiedifferenz zwischen von der ersten Leuchtdiode emittierten Photonen und von dem ersten Leuchtstoff emittierten Photonen und/oder die mittlere Energiedifferenz zwischen von der zweiten Leuchtdiode emittierten Photonen und von dem zweiten Leuchtstoff emittierten Photonen reduziert werden kann. Ferner kann die dritte Leuchtdiode zu einer Verbesserung des Farbwiedergabeindexes beitragen, insbesondere wenn die dritte Leuchtdiode separat von der ersten und der zweiten Leuchtdiode angesteuert werden kann.

Gemäß einer weiteren Ausführungsform weist das Leuchtmittel ferner einen dritten Leuchtstoff auf, wobei ein Emissionsspektrum des dritten Leuchtstoffs ein Maximum bei einer achten Wellenlänge aufweist, und wobei die achte Wellenlänge größer als die siebte Wellenlänge ist.

Der dritte Leuchtstoff kann dazu ausgeführt sein, zumindest einen Teil des von der dritten Leuchtdiode emittierten Lichts in längerwelliges Licht zu konvertieren. Der dritte Leuchtstoff kann eine Aufteilung des sichtbaren Spektralbereichs in schmalbandigere Abschnitte ermöglichen. Dies kann eine Verbesserung des Wirkungsgrads des Leuchtmittels ermöglichen, da die mittlere Energiedifferenz zwischen von der ersten Leuchtdiode emittierten Photonen und von dem ersten Leuchtstoff emittierten Photonen und/oder die mittlere Energiedifferenz zwischen von der zweiten Leuchtdiode emittierten Photonen und von dem zweiten Leuchtstoff emittierten Photonen reduziert werden kann.

Im Folgenden werden Ausführungsbeispiele der Erfindung unter Bezugnahme auf die Figuren beschrieben.

Kurze Beschreibung der Figuren
Fig. 1 veranschaulicht ein Leuchtmittel gemäß einem Ausführungsbeispiel der Erfindung.
Fig. 2 veranschaulicht ein Emissionsspektrum eines Leuchtmittels gemäß einem Ausführungsbeispiel der Erfindung.

### Detaillierte Beschreibung von Ausführungsbeispielen

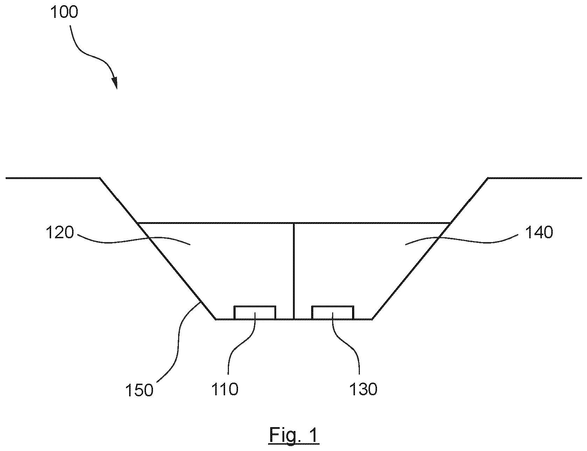

Fig. 1 veranschaulicht ein Leuchtmittel 100 gemäß einem Ausführungsbeispiel der Erfindung. Das Leuchtmittel 100 weist eine erste Leuchtdiode 110 und eine zweite Leuchtdiode 130 auf. Wie in Fig. 1 dargestellt können die Leuchtdioden 110, 130 auf dem Boden einer trichterförmigen Vertiefung 150 angeordnet sein. Bei der trichterförmigen Vertiefung 150 kann es sich beispielsweise um eine kegelstumpfförmige oder eine pyramidenstumpfförmige Vertiefung handeln. Die Innenseiten der Vertiefung 150 können dazu ausgeführt sein, von den Leuchtdioden 110, 130 emittiertes Licht zu reflektieren. Die Anordnung der Leuchtdioden 110, 130 auf dem Boden einer trichterförmigen Vertiefung ist optional.

Ferner weist das Leuchtmittel 100 eine erste Schicht mit einem ersten Leuchtstoff 120 und eine zweite Schicht mit einem zweiten Leuchtstoff 140 auf. Bei der ersten Schicht kann es sich beispielsweise um eine Epoxidharzschicht handeln, in der sich Partikel des ersten Leuchtstoffs 120 befinden. Ähnlich dazu kann es sich bei der zweiten Schicht um eine Epoxidharzschicht handeln, in der sich Partikel des zweiten Leuchtstoffs 140 befinden.

In der in Fig. 1 dargestellten Ausführungsform grenzt die erste Schicht mit dem ersten Leuchtstoff 120 unmittelbar an die erste Leuchtdiode 110 an und die zweite Schicht mit dem zweiten Leuchtstoff 140 grenzt unmittelbar an die zweite Leuchtdiode 130 an. In einer weiteren Ausführungsform (nicht dargestellt) ist die erste Schicht mit dem ersten Leuchtstoff 120 von der ersten Leuchtdiode 110 beabstandet und/oder die zweite Schicht mit dem zweiten Leuchtstoff 140 ist von der zweiten Leuchtdiode 130 beabstandet.

Die Emissionsspektra der ersten Leuchtdiode 110, der zweiten Leuchtdiode 130, des ersten Leuchtstoffs 120 und des zweiten Leuchtstoffs 140 weisen jeweils Maxima bei einer ersten, einer zweiten, einer dritten und einer vierten Wellenlänge auf. Dabei ist die zweite Wellenlänge größer als die erste Wellenlänge, die dritte Wellenlänge ist größer als die zweite Wellenlänge, und die vierte Wellenlänge ist größer als die dritte Wellenlänge.

Die erste Leuchtdiode 110 kann dazu ausgeführt sein, blaues oder ultraviolettes Licht abzustrahlen. Die erste Leuchtdiode 110 und der erste Leuchtstoff 120 können dazu ausgeführt sein, dass mehr als 20%, mehr als 40% oder mehr als 80% der von der ersten Leuchtdiode bei der ersten Wellenlänge abgestrahlten Photonen von dem ersten Leuchtstoff in längerwelliges Licht konvertiert werden. Ferner kann der erste Leuchtstoff 120 dazu ausgeführt sein, blaues und/oder grünes Licht zu emittieren. Das Emissionsspektrum des ersten Leuchtstoffs 120 weist vorzugsweise eine Halbwertsbreite von weniger als 150 nm, weniger als 100 nm oder weniger als 75 nm auf. Der Abstand zwischen dem Absorptionsband und dem Emissionsband des ersten Leuchtstoffs 120 ist vorzugsweise klein. Beispielsweise weisen einige Eu²⁺ aktivierte Leuchtstoffe kleine Abstände zwischen dem Absorptionsband und dem Emissionsband auf. Insbesondere kann der erste Leuchtstoff BaMgAl₁₀O₁₇:Eu²⁺, Sr₅(PO₄)₃Cl:Eu²⁺ und/oder (Sr,Ca,Ba)₅(PO₄)₃Cl:Eu²⁺ aufweisen.

Die zweite Leuchtdiode 130 kann dazu ausgeführt sein, grünes oder gelbes Licht zu emittieren. Die zweite Leuchtdiode 130 und der zweite Leuchtstoff 140 können dazu ausgeführt sein, dass mehr als 20%, mehr als 40% oder mehr als 80% der von der zweiten Leuchtdiode bei der dritten Wellenlänge abgestrahlten Photonen von dem zweiten Leuchtstoff in längerwelliges Licht konvertiert werden. Ferner kann der zweite Leuchtstoff 140 dazu ausgeführt sein, gelbes, oranges und/oder rotes Licht zu emittieren. Das Emissionsspektrum des zweiten Leuchtstoffs 140 weist vorzugsweise eine Halbwertsbreite von weniger als 150 nm, weniger als 100 nm oder weniger als 75 nm auf. Der Abstand zwischen dem Absorptionsband und dem Emissionsband des zweiten Leuchtstoffs 140 ist vorzugsweise klein. Beispielsweise weist der zweite Leuchtstoff Ba₂Si₅N₈:Eu²⁺, MgS:Eu²⁺, SrS:Eu²⁺, Sr₂Si₅N₈:Eu²⁺, CaAlSiN₃:Eu²⁺, CaS:Eu²⁺ und/oder Sr(LiAl₃N₄):Eu²⁺ auf.

In der in Fig. 1 dargestellten Ausführungsform können von der ersten Leuchtdiode 110 und von dem ersten Leuchtstoff 120 emittierte Photonen auf die Schicht mit dem zweiten Leuchtstoff 140 treffen. Daher kann der zweite Leuchtstoff 140 in dieser Ausführungsform vorzugsweise dazu ausgeführt sein, weniger als 20%, weniger als 10%, oder weniger als 5% des von der ersten Leuchtdiode 110 und dem ersten Leuchtstoff 120 emittierten Lichts zu absorbieren. Ferner treffen von der zweiten Leuchtdiode 130 und dem zweiten Leuchtstoff 140 emittierte Photonen auf die Schicht mit dem ersten Leuchtstoff 120. Daher kann der erste Leuchtstoff 120 in dieser Ausführungsform vorzugsweise dazu ausgeführt sein, weniger als 20%, weniger als 10%, oder weniger als 5% des von der zweiten Leuchtdiode 130 und dem zweiten Leuchtstoff 140 emittierten Lichts zu absorbieren. Die hier genannten Bedingungen können die Wahl der Leuchtstoffe 120, 140 stark einschränken.

In einer weiteren Ausführungsform (nicht dargestellt) können die zuletzt genannten Bedingungen betreffend die Wahl der Leuchtstoffe 120, 140 vermieden werden. Dazu kann das Leuchtmittel 100 eine erste trichterförmige Vertiefung und eine zweite trichterförmige Vertiefung aufweisen, wobei die erste Leuchtdiode 110 und der erste Leuchtstoff 120 in der ersten trichterförmigen Vertiefung angeordnet sind, wohingegen die zweite Leuchtdiode 130 und der zweite Leuchtstoff 140 in der zweiten trichterförmigen Vertiefung angeordnet sind. Die trichterförmigen Vertiefungen können vermeiden, dass von der ersten Leuchtdiode 110 und dem ersten Leuchtstoff 120 emittierte Photonen auf geradem Weg auf den zweiten Leuchtstoff 140 treffen und dass von der zweiten Leuchtdiode 130 und dem zweiten Leuchtstoff 140 emittierte Photonen auf geradem Weg auf den ersten Leuchtstoff 120 treffen. Diese Ausführungsform hat auch den Vorteil, dass eine Vermischung der ersten und zweiten Leuchtstoffe auf einfache Weise vermieden werden kann. Die trichterförmigen Vertiefungen können beispielsweise kegelstumpfförmige oder pyramidenstumpfförmige Vertiefungen sein.

In einer weiteren Ausführungsform (nicht dargestellt) umfasst das Leuchtmittel ein erstes Gehäuse und/oder ein zweites Gehäuse, wobei das erste Gehäuse zum Schutz der ersten Leuchtdiode 110 und des ersten Leuchtstoffs 120 ausgeführt ist, und wobei das zweite Gehäuse zum Schutz der zweiten Leuchtdiode 130 und des zweiten Leuchtstoffs 140 ausgeführt ist. Die erste Leuchtdiode 110 und der erste Leuchtstoff 120 können in dem ersten Gehäuse angeordnet sein, und die zweite Leuchtdiode 130 und der zweite Leuchtstoff 140 können in dem zweiten Gehäuse angeordnet sein. Dabei können das erste und das zweite Gehäuse auf einer Leiterplatte montiert sein. Es ist auch möglich, dass das Leuchtmittel mehrere erste Gehäuse und mehrere zweite Gehäuse aufweist, wobei in den ersten Gehäusen jeweils eine erste Leuchtdiode 110 und ein erster Leuchtstoff 120 angeordnet sind, und wobei in den zweiten Gehäusen jeweils eine zweite Leuchtdiode 130 und ein zweiter Leuchtstoff 140 angeordnet sind. Beispielsweise können auf einer Leiterplatte abwechselnd erste und zweite Gehäuse mit den jeweiligen Leuchtdioden und Leuchtstoffen montiert sein. Die zweiten Gehäuse können wie die ersten Gehäuse ausgeführt sein, jedoch sind in den ersten Gehäusen jeweils eine erste Leuchtdiode 110 und ein erster Leuchtstoff 120 angeordnet, während in den zweiten Gehäusen jeweils eine zweite Leuchtdiode 130 und ein zweiter Leuchtstoff 140 angeordnet sind. Es ist auch möglich, dass sich die zweiten Gehäuse in Form und/oder Material von den ersten Gehäusen unterscheiden. Die ersten und zweiten Gehäuse können kegelstumpfförmige, pyramidenstumpfförmige oder andere trichterförmige Vertiefungen umfassen, ähnlich den trichterförmigen Vertiefungen 150 wie in Fig. 1 veranschaulicht. Eine Wand des ersten Gehäuses und/oder eine Wand des zweiten Gehäuses kann zumindest teilweise aus einem für sichtbares Licht transparenten Material gefertigt sein, beispielsweise aus Glas oder Kunststoff. Eine Wand des ersten Gehäuses kann insbesondere auf einer Innenseite mit dem ersten Leuchtstoff beschichtet sein, und/oder eine Wand des zweiten Gehäuses kann insbesondere auf einer Innenseite mit dem zweiten Leuchtstoff beschichtet sein. Eine Vermischung der ersten und zweiten Leuchtstoffe kann wiederum auf einfache Weise vermieden werden.

In einer weiteren Ausführungsform (nicht dargestellt) können die erste Leuchtdiode 110 und die zweite Leuchtdiode 130 auf einer ebenen Fläche angeordnet sein. Eine Schicht mit dem ersten Leuchtstoff 120 kann die erste Leuchtdiode 110 umgeben oder derart angeordnet sein, dass ein großer Teil (mehr als 60%, mehr als 80% oder mehr als 90%) der von der ersten Leuchtdiode 110 emittierten Photonen auf diese Schicht trifft, wohingegen nur ein kleiner Teil (weniger als 40%, weniger als 20% oder weniger als 10%) der von der zweiten Leuchtdiode 130 und/oder dem zweiten Leuchtstoff 140 emittierten Photonen auf die Schicht mit dem ersten Leuchtstoff 120 trifft. In ähnlicher Weise kann eine Schicht mit dem zweiten Leuchtstoff 140 die zweite Leuchtdiode 130 umgeben oder derart angeordnet sein, dass ein großer Teil (mehr als 60%, mehr als 80% oder mehr als 90%) der von der zweiten Leuchtdiode 130 emittierten Photonen auf diese Schicht trifft, wohingegen nur ein kleiner Teil (weniger als 40%, weniger als 20% oder weniger als 10%) der von der ersten Leuchtdiode 110 und/oder dem ersten Leuchtstoff 120 emittierten Photonen auf die Schicht mit dem zweiten Leuchtstoff 140 trifft. Dies kann beispielsweise durch einen hinreichend großen Abstand der ersten Leuchtdiode von der zweiten Leuchtdiode erreicht werden.

In einer weiteren Ausführungsform (nicht dargestellt) befindet sich die Schicht mit dem zweiten Leuchtstoff 140 über der Schicht mit dem ersten Leuchtstoff 120, sodass von den Leuchtdioden 110, 130 emittierte Photonen durch die Schicht mit dem ersten Leuchtstoff propagieren müssen, um auf die Schicht mit dem zweiten Leuchtstoff 140 zu treffen.

In einer weiteren Ausführungsform (nicht dargestellt) befindet sich die Schicht mit dem ersten Leuchtstoff 120 über der Schicht mit dem zweiten Leuchtstoff 140, sodass von den Leuchtdioden 110, 130 emittierte Photonen durch die Schicht mit dem zweiten Leuchtstoff propagieren müssen, um auf die Schicht mit dem ersten Leuchtstoff 120 zu treffen.

In einer weiteren Ausführungsform (nicht dargestellt) weist das Leuchtmittel eine einzige Schicht auf, in der Partikel des ersten Leuchtstoffs 120 und des zweiten Leuchtstoffs 140 gemischt sind.

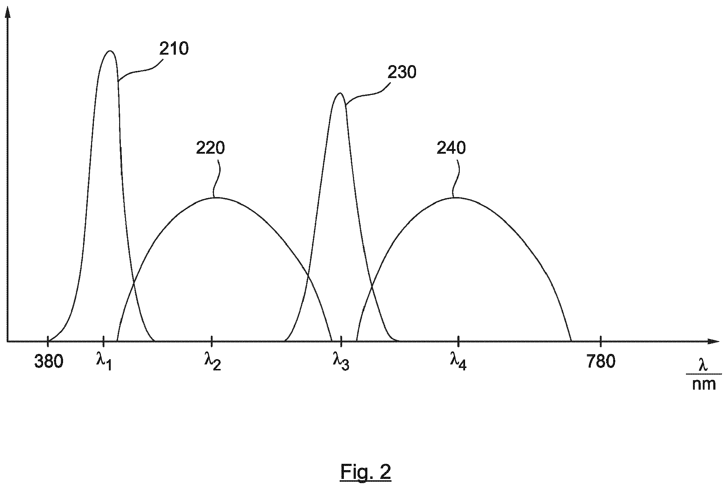

Die Fig. 2 veranschaulicht ein Emissionsspektrum eines Leuchtmittels gemäß einem Ausführungsbeispiel der Erfindung. Dabei ist das Emissionsspektrum als Funktion der Wellenlänge dargestellt.

Eine erste Kurve veranschaulicht das Emissionsspektrum 210 der ersten Leuchtdiode 110. Das Emissionsspektrum 210 der ersten Leuchtdiode weist ein Maximum bei einer ersten Wellenlänge λ₁ auf.

Eine zweite Kurve veranschaulicht das Emissionsspektrum 220 des ersten Leuchtstoffs 120. Das Emissionsspektrum 220 des ersten Leuchtstoffs weist ein Maximum bei einer zweiten Wellenlänge λ₂ > λ₁ auf.

Eine dritte Kurve veranschaulicht das Emissionsspektrum 230 der zweiten Leuchtdiode 130. Das Emissionsspektrum 230 der zweiten Leuchtdiode weist ein Maximum bei einer dritten Wellenlänge λ₃ > λ₂ auf.

Eine vierte Kurve veranschaulicht das Emissionsspektrum 240 des zweiten Leuchtstoffs 140. Das Emissionsspektrum 240 des zweiten Leuchtstoffs weist ein Maximum bei einer zweiten Wellenlänge λ₄ > λ₃ auf.

Das Gesamtemissionsspektrum des Leuchtmittels 100 ergibt sich aus einer Kombination der Emissionsspektren 210, 220, 230 und 240. Das Gesamtemissionsspektrum 200 deckt den gesamten sichtbaren Spektralbereich ab. Wenn die erste Leuchtdiode 110 und die zweite Leuchtdiode 130 separat voneinander ansteuerbar sind, können die Emissionsspektren 230 und 240 relativ zu den Emissionsspektren 210 und 220 verstärkt oder abgeschwächt werden. Dadurch können unterschiedliche Farbtemperaturen eingestellt werden. Ferner kann das Leuchtmittel 100 dazu ausgeführt sein, dass über eine entsprechende Ansteuerung der Leuchtdioden 110 und 130 hohe Farbwiedergabeindizes (color rendering indices, CRIs) erreicht werden können.

Das Leuchtmittel 100 weist somit mehrere Leuchtstoffe 120, 140 auf, die von separaten Leuchtdioden 110, 130 zum Leuchten angeregt werden. Das Leuchtmittel 100 kann weißes Licht bereitstellen, wobei die mittlere Energiedifferenz zwischen den von der ersten Leuchtdiode 110 und den von dem ersten Leuchtstoff 120 emittierten Photonen sowie die mittlere Energiedifferenz zwischen den von der zweiten Leuchtdiode 130 und den von dem zweiten Leuchtstoff 140 emittierten Photonen gering ist. Dadurch kann weißes Licht in energieeffizienter Art und Weise bereitgestellt werden.

Ergänzend sei darauf hingewiesen, dass "umfassend" und "aufweisend" keine anderen Elemente ausschließen und die unbestimmten Artikel "eine" oder "ein" keine Vielzahl ausschließen. Ferner sei darauf hingewiesen, dass Merkmale, die mit Verweis auf eines der obigen Ausführungsbeispiele beschrieben worden sind, auch in Kombination mit anderen Merkmalen anderer oben beschriebener Ausführungsbeispiele verwendet werden können.

### Bezugszeichenliste

- 100: Leuchtmittel
- 110: Erste Leuchtdiode
- 120: Erster Leuchtstoff
- 130: Zweite Leuchtdiode
- 140: Zweiter Leuchtstoff
- 150: Trichterförmige Vertiefung
- 210: Emissionsspektrum der ersten Leuchtdiode
- 220: Emissionsspektrum des ersten Leuchtstoffs
- 230: Emissionsspektrum der zweiten Leuchtdiode
- 240: Emissionsspektrum des zweiten Leuchtstoffs

## Patentansprüche

1. Leuchtmittel (100), aufweisend
eine erste Leuchtdiode (110), wobei ein Emissionsspektrum (210) der ersten Leuchtdiode ein Maximum bei einer ersten Wellenlänge aufweist;
einen ersten Leuchtstoff (120), wobei ein Emissionsspektrum (220) des ersten Leuchtstoffs ein Maximum bei einer zweiten Wellenlänge aufweist, und wobei die zweite Wellenlänge größer als die erste Wellenlänge ist;
eine zweite Leuchtdiode (130), wobei ein Emissionsspektrum (230) der zweiten Leuchtdiode ein Maximum bei einer dritten Wellenlänge aufweist, wobei die dritte Wellenlänge größer als die zweite Wellenlänge ist; und
einen zweiten Leuchtstoff (140), wobei ein Emissionsspektrum (240) des zweiten Leuchtstoffs ein Maximum bei einer vierten Wellenlänge aufweist, und wobei die vierte Wellenlänge größer als die dritte Wellenlänge ist.

2. Leuchtmittel (100) nach Anspruch 1,
wobei die erste Wellenlänge größer als 400 nm und/oder kleiner als 500 nm ist.

3. Leuchtmittel (100) nach Anspruch 1 oder 2,
wobei die erste Leuchtdiode (110) Indiumgalliumnitrid, Galliumnitrid, Zinkselenid, Siliziumkarbid, Silizium als Träger, und/oder Zinkoxid aufweist.

4. Leuchtmittel (100) nach einem der vorhergehenden Ansprüche,
wobei die erste Wellenlänge innerhalb einer Halbwertsbreite eines Absorptionsspektrums des ersten Leuchtstoffs (120) liegt; und/oder
wobei die dritte Wellenlänge innerhalb einer Halbwertsbreite eines Absorptionsspektrums des zweiten Leuchtstoffs (140) liegt.

5. Leuchtmittel (100) nach einem der vorhergehenden Ansprüche,
wobei ein Absorptionsspektrum des ersten Leuchtstoffs (120) ein Maximum bei einer fünften Wellenlänge aufweist, und wobei eine Differenz zwischen der zweiten Wellenlänge und der fünften Wellenlänge kleiner als 150 nm ist; und/oder
wobei ein Absorptionsspektrum des zweiten Leuchtstoffs (140) ein Maximum bei einer sechsten Wellenlänge aufweist, und wobei eine Differenz zwischen der vierten Wellenlänge und der sechsten Wellenlänge kleiner als 170 nm ist.

6. Leuchtmittel (100) nach einem der vorhergehenden Ansprüche,
wobei das Emissionsspektrum (220) des ersten Leuchtstoffs (120) und/oder des zweiten Leuchtstoffs (140) eine Halbwertsbreite von weniger als 100 nm aufweist.

7. Leuchtmittel (100) nach einem der vorhergehenden Ansprüche,
wobei der erste Leuchtstoff (120) und/oder der zweite Leuchtstoff (140) ein Eu²⁺ aktivierter Leuchtstoff ist.

8. Leuchtmittel (100) nach einem der vorhergehenden Ansprüche,
wobei der erste Leuchtstoff (120) BaMgAl₁₀O₁₇:Eu²⁺, Sr₅(PO₄)₃Cl:Eu²⁺ und/oder (Sr,Ca,Ba)₅(PO₄)₃Cl:Eu²⁺ aufweist.

9. Leuchtmittel (100) nach einem der vorhergehenden Ansprüche,
wobei die dritte Wellenlänge größer als 500 und/oder kleiner als 570 nm ist.

10. Leuchtmittel (100) nach einem der vorhergehenden Ansprüche,
wobei die zweite Leuchtdiode (130) Galliumphosphid, Indiumgalliumnitrid/Galliumnitrid, Aluminiumgalliumindiumphosphid, Aluminiumgalliumphosphid und/oder Zinkoxid aufweist.

11. Leuchtmittel (100) nach einem der vorhergehenden Ansprüche,
wobei die vierte Wellenlänge kleiner ist als 700 nm.

12. Leuchtmittel (100) nach einem der vorhergehenden Ansprüche,
wobei der zweite Leuchtstoff (140) Ba₂Si₅N₈:Eu²⁺, MgS:Eu²⁺, SrS:Eu²⁺, Sr₂Si₅N₈:Eu²⁺, CaAlSiN₃:Eu²⁺, CaS:Eu²⁺ und/oder Sr(LiAl₃N₄):Eu²⁺ aufweist.

13. Leuchtmittel (100) nach einem der vorhergehenden Ansprüche,
ferner aufweisend:
eine dritte Leuchtdiode, wobei ein Emissionsspektrum der dritten Leuchtdiode ein Maximum bei einer siebten Wellenlänge aufweist, wobei die siebte Wellenlänge größer als die vierte Wellenlänge ist; und/oder
einen dritten Leuchtstoff, wobei ein Emissionsspektrum des dritten Leuchtstoffs ein Maximum bei einer achten Wellenlänge aufweist, und wobei die achte Wellenlänge größer ist als die siebte Wellenlänge ist.

14. Leuchte umfassend ein Leuchtmittel (100) nach einem der vorhergehenden Ansprüche.
